Europäisches Patentamt

(19) European Patent Office     (11) Publication number:     **0 114 736**
**B1**
Office européen des brevets

(12)                          EUROPEAN PATENT SPECIFICATION

(45) Date of publication of patent specification: **22.10.86**     (51) Int. Cl.⁴: **C 30 B 13/10**

(21) Application number: **84300221.3**

(22) Date of filing: **13.01.84**

(54) Method of controlled, uniform doping of floating zone silicon.

(30) Priority: **14.01.83 US 458222**

(43) Date of publication of application:
**01.08.84 Bulletin 84/31**

(45) Publication of the grant of the patent:
**22.10.86 Bulletin 86/43**

(84) Designated Contracting States:
**BE DE FR GB**

(56) References cited:
**DE-A-2 415 717**
**FR-A-1 236 935**

(73) Proprietor: **WESTINGHOUSE ELECTRIC**
**CORPORATION**
**Westinghouse Building Gateway Center**
**Pittsburgh Pennsylvania 15235 (US)**

(72) Inventor: **Thomas, Richard Noel**
**3441 MacArthur Drive**
**Murrysville Pennsylvania (US)**
Inventor: **Hobgood, Hudson McDonald**
**4751 Nob Hill Drive**
**Murrysville Pennsylvania (US)**
Inventor: **Swartz, John Croucher**
**3201 Cambridge Drive**
**Murrysville Pennsylvania (US)**

(74) Representative: **van Berlyn, Ronald Gilbert**
**23, Centre Heights**
**London, NW3 6JG (GB)**

# Description

The present invention relates generally to the making of silicon crystal rods from which silicon wafers are sectioned for use in the fabrication of semiconductor integrated circuits, and more particularly to a method of producing a single crystal rod of silicon with a controlled content of a desired impurity distributed substantially uniformly throughout the silicon single crystal rod.

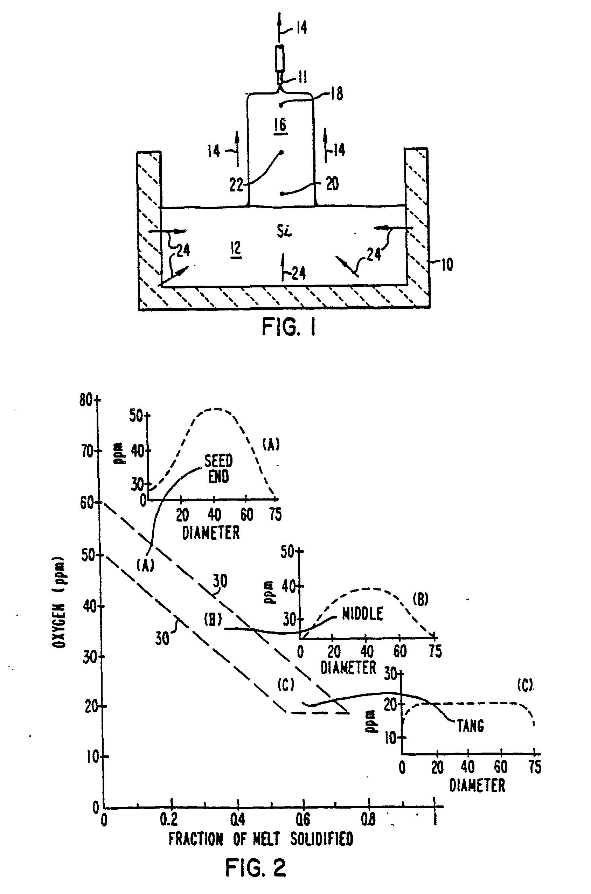

Generally, for the semiconductor integrated circuit industry today, silicon crystals are grown by the Czochralski crystal-pulling process. The heated crucible portion of the furnace, which holds molten silicon, is illustrated in Figure 1. Referring to Figure 1, the crucible 10 may be made of a material such as fused silica (or quartz). To initiate single crystal growth, a very pure seed crystal 11 is dipped into the molten silicon 12 contained in the crucible 10 and thereafter pulled from the molten silicon 12 at a controlled rate as denoted by the arrows 14, while the melt is cooled at a controlled rate. As the crystal 11 moves upward it brings along with it (i.e. grows) a crystalline rod 16 of solid silicon. The end 18 of the rod 16 closest to the pure crystal 11 is referred to as the seed end. The other end 20 closest to the silicon melt 12 is referred to as the tang end. And, of course the middle section 22 of the rod 16 is referred to as the middle.

Generally, as a result of the dissolution of the crucible 10 during the Czochralski process, certain impurities may be incorporated into the silicon melt 12 as denoted by the arrows 24 in Figure 1. In most cases, the majority impurity in the silicon melt 12 is oxygen rendered from the fused silica of the crucible 10. Varying amounts of oxygen impurities are thus incorporated into the crystal rod 16 during the crystal-pulling formation thereof. As shown from the graph of Figure 2, the axial and radial distribution of oxygen concentration in the crystal rod 16 is very nonuniform. The region within the dashed lines 30 of the graph of Figure 2 is typical of the oxygen distribution along the length of the crystal rod 16. The curves A, B, C, are representative of typical oxygen distribution across the diameter of the crystal rod at the seed, middle, and tang ends of the rod 16, respectively. For example, at the seed end the oxygen distribution may range from 30 to 50 parts per million and at the tang end the range is reduced to from 10 to 20 parts per million. In addition, as illustrated by the graph of Figure 2, there is also a large axial oxygen distribution nonuniformity.

Originally, it was thought that this unintentional oxygen doping of silicon in the crystalline rod 16 during crystal growth was detrimental to the application of the grown silicon to the semiconductor industry. However, it was later identified that the oxygen doped silicon produced by the Czochralski process yielded certain characteristics particularly advantageous for use in semiconductor integrated circuit fabrication. More specifically, the oxygen present in the grown silicon rod is beneficial in avoiding warpage of a silicon wafer sectioned therefrom during the multiple heat-cycles of the integrated circuit fabrication process, and in providing an "intrinsic" gettering mechanism for lifetime killing of metallic impurities which may be present in such silicon wafers, as a result of contamination during growth or are introduced during subsequent integrated circuit processing steps.

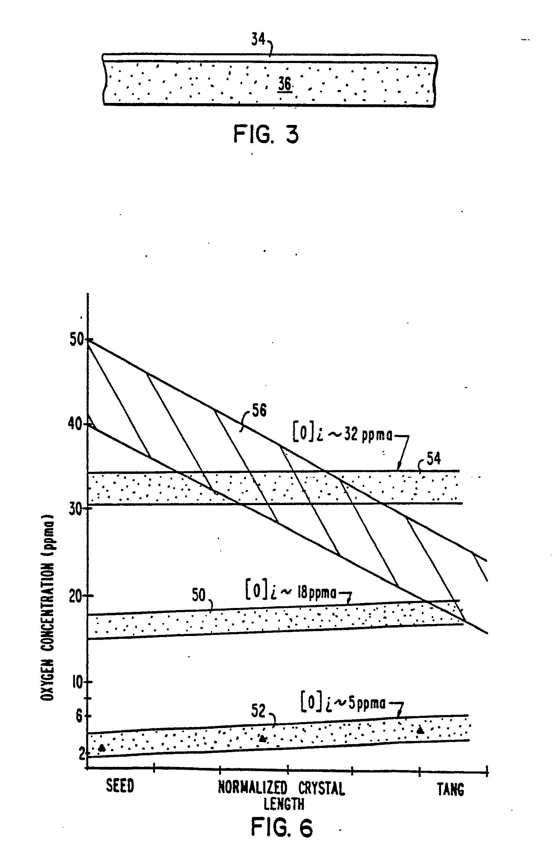

Intrinsic gettering is a thermal processing step in which a silicon wafer taken from the crystal rod 16 is exposed to a high temperature anneal in an inert atmosphere during the integrated circuit fabrication process. A cross-sectional view of a typical silicon wafer is shown in Figure 3. During this anneal process step, a region 34, called a denuded zone, relatively free of crystalline defects, forms near the surface of the wafer while crystalline imperfections associated with the silicon oxide precipitates form in the bulk region 36 of the silicon substrate or wafer. These crystalline imperfections act as self-gettering sites and are believed to be an important factor in maintaining high carrier lifetimes throughout a large scale integrated circuit fabrication process.

Unfortunately, the oxygen doped silicon yielded by the Czochralski process also has its disadvantages especially in its appication to current very large scale integrated (VLSI) circuit fabrication. First, the silicon produced is not very pure usually containing on the order of $10^{14}$—$10^{15}$ cm$^{-3}$ boron and $10^{16}$—$10^{17}$ cm$^{-3}$ carbon impurities. In addition, the Czochralski silicon growth method neither provides for uniform oxygen distribution nor permits easy control of oxygen content of the silicon grown boules (see Figure 2, for example). In its application to current VLSI semiconductor processing, the non-uniform oxygen concentrations in the grown silicon boules may give rise to relatively large numbers of microdefects in the denuded zone of the silicon wafers sliced therefrom. Such high densities of deleterious defects in this active device region are not compatible with large scale, high speed integrated circuits which generally require nearly defect-free silicon surfaces in which uniform oxygen contents not greater than 10 to 20 parts per million may be required.

Another well known technique for preparing large diameter silicon crystals is the float zone process which is capable of producing very pure, low defect density silicon. The resulting silicon is used primarily for semiconductor devices requiring excellent bulk properties and high minority carrier lifetimes, such as power devices, for example. In the float-zone process, a polycrystalline silicon rod is passed through a heating zone which melts the portion of the silicon rod being heated which upon cooling becomes of a single crystalline structure. Owing to the way in which the float-zone process is conventionally carried out, the resulting single crystal silicon boule contains substantially no oxygen (typically 0.1 ppma) and therefore, is not used for integrated circuit fabrication since the wafers taken therefrom exhibit a high degree of warpage after multiple fabrication heat-cycles and in addition, exhibit no intrinsic gettering mechanism due to the lack of oxygen therein. To alleviate these drawbacks, oxygen doping of high purity float zone polycrystalline silicon has been tried in the past by, for example, float zoning in an oxygen ambient, but these attempts have been unsuccessful due to melt instabilities associated with the formation of an oxide "scum" on the molten silicon heating zone surface, which results in a lack of single crystalline growth.

In view of the above, there appears to be presented somewhat of a dilemma. The Czochralski process provides the unintentional oxygen doping of the silicon crystals which allow for their use in integrated circuit fabrication due to the aforementioned advantages of the oxygen doping therein. However the inability to control the absolute amounts and the uniformity of the oxygen concentrations throughout the silicon crystal grown by the Czochralski process results in various disadvantages. On the other hand, the float zone process for producing silicon crystals provides essentially no oxygen thus reducing the application thereof in the semiconductor area to only devices which require certain bulk property characteristics. To extend the application of the silicon crystal produced from the float-zone process to a more widespread use in integrated circuit fabrication, it is desirable to incorporate oxygen or some other advantageous impurity deep into the polycrystalline structure as part of the crystal growth process in some controlled amount and uniform concentration levels within an amenable range. However, heretofore attempts at introducing oxygen into the silicon crystal formed by the high purity float-zone process by conventional doping have been generally unsuccessful. It is the principal object of the invention to provide a single crystal with polyatomic impurities.

The invention resides broadly in a method of producing a single crystal rod of silicon with a controlled content of a desired impurity distributed substantially uniformly throughout said silicon crystal rod, said method including the steps of: diffusing a polyatomic gaseous element as a desired impurity into the bulk of a polycrystalline rod of silicon, and converting said diffused polycrystalline silicon rod into a single crystal rod of silicon by a float-zoning process.

More specifically, the step of diffusing includes the steps of doping the polycrystalline silicon rod with the desired impurity by diffusing the atoms of the polyatomic gaseous element along the grain-boundary surfaces of the small crystallites in a spatially heterogeneous fashion within the polycrystalline silicon rod; and controlling the concentration of the desired impurity dopant in the polycrystalline silicon rod by performing the diffusion of the gaseous element for a predetermined time at a predetermined temperature.

In one embodiment, the polycrystalline silicon rod is placed into a diffusion furnace set at a predetermined temperature; and thereafter, a controlled flow of the polyatomic gaseous element is established across the polycrystalline silicon rod for a predetermined time duration. Accordingly, the polycrystalline silicon rod may be diffused in a substantially wet or dry oxygen environment. In some cases, the polycrystalline silicon rod may be diffused in a substantially nitrogen environment. The step of converting may be performed in either a substantially inert gas or vacuum environment.

Preferred embodiments are described hereafter for exemplary purposes only in accordance with the following drawings:

Figure 1 is an illustration of the conventional Czochralski process for growing silicon crystals in an industrial crystal-pulling crucible furnace;

Figure 2 is a graph exemplifying the axial and radial distribution of oxygen concentration in a crystal rod grown by the Czochralski process;

Figure 3 is a cross-sectional view of a typical silicon wafer illustrating a denuded zone relatively free of crystalline defects formed near the top surface thereof;

Figures 4 and 5 are illustrations which relate to a two-step process including the control diffusion of a polyatomic gaseous element into a polycrystalline silicon rod and, the subsequent conversion of the diffused rod into a single crystal of silicon by a float-zone method of crystal growth; and

Figure 6 is a graph which compares the oxygen concentrations of the single silicon crystal boules grown by the process described in connection with the illustrations of Figures 4 and 5 with the oxygen concentration of a typical silicon boule grown by the Czochralski method.

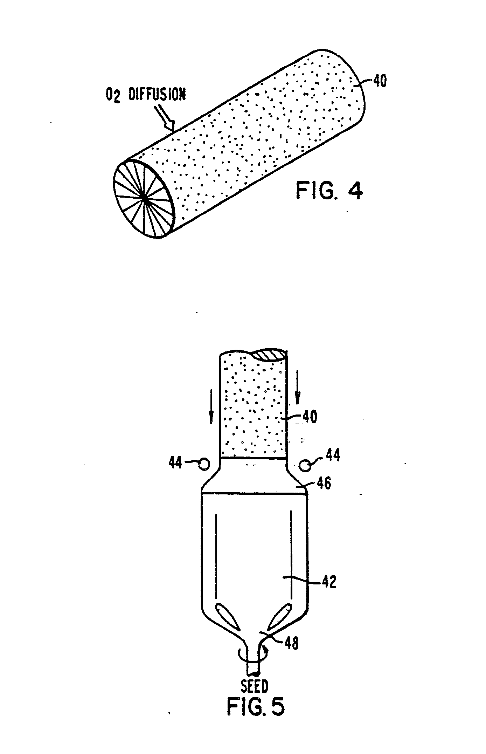

The method of producing a single crystal rod of silicon with a controlled content of a desired impurity distributed substantially uniformly throughout the silicon crystal rod is exhibited in the illustrations of Figures 4 and 5 which relate to a two-step process including the controlled diffusion of a polyatomic gaseous element like oxygen or nitrogen, for example, into a polycrystalline silicon rod (Figure 4) and, the subsequent conversion of the diffused rod into a single crystal of silicon by a float-zone method of crystal growth (Figure 5). In contrast to the conventional Czochralski growth method, the present method results in a reproducible technique for the fabrication of silicon crystals containing a controlled amount of the desired impurity which is distributed substantially uniformly throughout the crystal. For example if oxygen is desired, the process may be controlled to diffuse up to 20 parts per million of oxygen substantially uniformly throughout the crystal.

More specifically, in the first step of the preferred process, a polycrystalline rod 40 is diffused in a controlled environment of a polyatomic gaseous element, like oxygen, for example. Because of the polycrystalline nature of the rod 40, the oxygen doping concentration is governed by the phenomenon of enhanced diffusion of oxygen atoms along the grain-boundary surfaces of the small crystallites in the rod 40. This process may be carried out by placing the polycrystalline silicon rod 40 in a diffusion furnace at a temperature preferably set at 1200 to 1300°C in which a flow of dry or wet oxygen is established. This thermal diffusion process distributes the oxygen in a spatially heterogeneous fashion throughout the bulk of the silicon rod 40. In a preferred experiment, a polycrystalline rod on the order of 1 to 2 inches (2.54—5.08 cm) in diameter was diffused in a diffusion furnace with a flow of dry oxygen at approximately 600 cm³ per minute at a temperature along the order of 1200°C for a time duration of 336 hours. It is understood however that the magnitude of the oxygen content in the polycrystalline silicon rod is determined by the environmental temperature and duration of time at which the diffusion is carried out.

In the second step of the preferred process as depicted in Figure 5, the polycrystalline silicon rod 40 which contains a level of oxygen as determined by the diffusion time and temperature of the first step, described hereabove, may be placed in a conventional float-zoning apparatus in an inert gas or vacuum ambient and converted by the float-zoning procedures thereof into an oxygen doped single crystal of silicon as shown at 42. This process is performed by moving the oxygen diffused polycrystalline silicon rod 40 through heating elements 44, such as RF coils, for example, which render a molten silicon zone 46 in the polysilicon rod 40. As the silicon rod passes through the heating zone comprising the coils 44, it solidifies into a single crystal silicon rod at 42. The final oxygen concentration of the float-zoned crystal at 42 is dependent primarily on the environmental diffusion parameters as described in connection with process step 1.

The crux of the inventive process is that in this crucible-free, float-zoning process owing to its near unity segregation coefficient, the oxygen will be distributed substantially uniformly both radially and axially throughout the silicon crystal as opposed to the silicon crystals grown by the conventional Czochralski technique which exhibits spatially nonuniform oxygen distributions. In addition, the high background purity characteristic of silicon produced by the conventional float-zoning process will be maintained substantially in the oxygen-doped, float-zoned silicon crystal formed since any deleterious heavy metal contamination resulting from the diffusion step 1 is removed during the float-zoning step of the process.

The graph of Figure 6 exhibits various experimental results in fabricating single silicon crystal boules with controlled, uniform oxygen concentrations. Curve portions 50, 52 and 54 depict the axial variations of the oxygen concentration of three oxygen-doped silicon crystals fabricated by the aforementioned float-zone procedure compared to the oxygen distribution of a typical silicon boule grown by the Czochralski method as shown by the curve region 56. For the curve region 52, a 30 millimeter diameter polycrystalline rod (Dow-Corning 111-0749-6) was diffusion annealed under a flow of dry-ultra-high purity oxygen in a 3 inch (7.62 cm) diameter diffusion furnace for 336 hours at 1200°C. The oxygen doped rod was then placed in a Westech (Model 145) float-zone refiner and float-zoned in the <111> orientation under an inert ultra high purity argon ambient at a pressure of 1000 Torr ($1.3\times10^5$ Pa) using a zoning rate of 2 millimeters/minute to produce a 30 millimeter diameter <111> oriented silicon crystal (see Figure 5). The oxygen concentrations in the resulting silicon crystal were determined by Fourier-transform infrared spectrometry using Digilab (FTS-14) IR spectrometer. The oxygen level at the crystal seed end (see Figure 5 at 48) was about $1\times10^{17}$ cm$^{-3}$ (2 ppma) and $2\times10^{17}$ cm$^{-3}$ (4 ppma) at the tail end.

The curve region 50 corresponds to a 25 millimeter diameter polycrystalline silicon rod (Topsil). This rod was diffusion annealed under the same conditions as used for curve region 52. After float-zoning in the <100> orientation under an inert argon ambient, the polysilicon rod yielded a 30 millimeter diameter silicon crystal having an oxygen concentration of 16 ppma ($8\times10^{17}$ cm$^{-3}$) at the seed end and a concentration of 18 ppma ($9\times10^{17}$ cm$^{-3}$) at the tang end.

The curve 54 corresponds to a polycrystalline silicon rod of similar dimensions as that of the other two rods associated with curves 50 and 52 and was diffusion-annealed under similar conditions. The diametric spread of oxygen concentration for this experimental example was centered about a level of approximately 32 ppma with very little axial change from the seed end to the tang end.

These representative experiments demonstrate that by utilizing the preferred procedure as described hereabove, float-zoned silicon crystals can be uniformly doped with a desired impurity like oxygen or nitrogen and the like, at levels up to approximately 32 ppma and that the axial uniformity of the oxygen distribution realized by this procedure represents a significant improvement over the distribution uniformities typical of conventional Czochralski-grown silicon boules.

Polycrystalline silicon rods having varying amounts of residual carbon content were investigated during the experimental process involving the above-described two-step method. The specific carbon content of the silicon rods ranged from <.26 ppma to approximately 1.5 ppma. While the diffused oxygen content in the silicon rods was observed to vary with a changing residual carbon content, the effect of the carbon content on oxygen incorporation in the silicon crystal was inconclusive.

While the method described hereabove used the gaseous element oxygen for diffusion, it is understood that other polyatomc gaseous elements such as nitrogen and the like may also be used without deviating from the broad principles of the present inventive method. The preferred method disclosed hereabove is intended for fabricating impurity doped float-zoned silicon boules which exhibit uniform concentrations of the desired impurity. This method, when applied to polycrystalline silicon rods, results in the production of high-purity float-zone silicon crystals with substantially uniform oxygen concentrations of up to 32 ppma which are not currently attainable utilizing the conventional Czochralski silicon boule fabrication methods of the semiconductor industry. The controlled doped silicon material resulting from the preferred process is of special interest in view of its potential as a high quality silicon substrate wafer material for very large scale, high speed integrated circuit applications.

## Claims

1. A method of producing a single crystal rod of silicon with a controlled content of a desired impurity distributed substantially uniformly throughout said silicon crystal rod, said method including the steps of: diffusing a polyatomic gaseous element as a desired impurity into the bulk of a polycrystalline rod of silicon, and converting said diffused polycrystalline silicon rod into a single crystal rod of silicon by a float-zoning process.

2. A method in accordance with claim 1 characterized in that the step of diffusing includes the steps of: doping the polycrystalline silicon rod with the desired impurity by diffusing the atoms of the polyatomic gaseous element along the grain-boundary surfaces of the small crystallites in a spatially heterogeneous fashion within the polycrystalline silicon rod; and controlling the concentration of the desired impurity dopant in the polycrystalline silicon rod by performing the diffusion of the gaseous element for a given time at a given temperature.

3. A method in accordance with claim 1 or 2 wherein the step of diffusing includes the steps of: placing the polycrystalline silicon rod into a diffusion furnace set at a given temperature; and thereafter, establishing a controlled flow of the polyatomic gaseous element across the polycrystalline silicon rod for a given time duration.

4. A method in accordance with claim 1, 2 or 3 characterized in that the step of converting is performed in a substantially inert gas environment.

5. A method in accordance with claim 1, 2 or 3 characterized in that the step of converting is performed in a substantially vacuum environment.

6. A method in accordance with claim 1, 2 or 3 characterized in that the polycrystalline silicon rod is diffused in a substantially wet oxygen environment.

7. A method in accordance with claim 1, 2 or 3 characterized in that the polycrystalline silicon rod is diffused in a substantially dry oxygen environment.

8. A method in accordance with claim 1, 2 or 3 characterized in that the polycrystalline silicon rod is diffused in a substantially nitrogen environment.

## Patentansprüche

1. Ein Verfahren zur Herstellung eines Silizium-Einkristallstabs mit einem kontrollierten Gehalt einer gewünschten Verunreinigung, die im wesentlichen gleichförmig in dem genannten Siliziumstab verteilt ist, wobei das genannte Verfahren die Schritte enthält: Diffundieren eines mehratomigen gasförmigen Elements als gewünschte Verunreinigung in das Volumen eines polykristallinen Siliziumstabs und Umwandeln des genannten diffundierten polykristallinen Siliziumstabs in einen Silizium-Einkristallstab durch einen Zonenschmelzprozess.

2. Ein Verfahren gemäß Anspruch 1, dadurch charakterisiert, daß der Diffusionschritt die Schritte enthält: Dotieren des polykristallinen Siliziumstabs mit der gewünschten Verunreinigung durch Diffusion der Atome des mehratomigen gasförmigen Elements längs Korngrenzenoberflächen der kleinen Kristallite in einer räumlich heterogenen Weise innerhalb des polykristallinen Siliziumstabs; und Steuern der Konzentration des gewünschten Verunreinigungsdotiermittels im polykristallinen Siliziumstab, indem die Diffusion des gasförmigen Elements während einer vorgegebenen Zeit bei einer vorgegebenen Temperatur durchgeführt wird.

3. Ein Verfahren gemäß Anspruch 1 oder 2, bei dem der Diffusionsschritt die Schritte enthält: Einbringen des polykristallinen Siliziumstabs in einen Diffusionsofen, der auf eine vorgegebene Temperatur eingestellt ist; und anschliessend Einstellen einer gesteuerten Strömung des mehratomigen gasförmigen Elements über den polykristallinen Siliziumstab während einer vorgegebenen Zeitdauer.

4. Ein Verfahren gemäß Anspruch 1, 2 oder 3, dadurch gekennzeichnet, daß der Umwandlungsschritt in einer Umgebung durchgeführt wird, die im wesentlichen aus einem Inertgas besteht.

5. Ein Verfahren gemäß Anspruch 1, 2 oder 3, dadurch gekennzeichnet, daß der Umwandlungsschritt in einer im wesentlichen aus Vakuum bestehenden Umgebung durchgeführt wird.

6. Ein Verfahren gemäß Anspruch 1, 2 oder 3, dadurch gekennzeichnet, daß die Diffusion des polykristallinen Siliziumstabs in einer Umgebung durchgeführt wird, die im wesentlichen aus feuchtem Sauerstoff besteht.

7. Ein Verfahren gemäß Anspruch 1, 2 oder 3, dadurch gekennzeichnet, daß die Diffusion des polykristallinen Silizumstabs in einer Umgebung durchgeführt wird, die im wesentlichen aus trockenem Sauerstoff besteht.

8. Ein Verfahren gemäß Anspruch 1, 2 oder 3, dadurch gekennzeichnet, daß die Diffusion des polykristallinen Siliziumstabs in einer Umgebung durchgeführt wird, die im wesentlichen aus Stickstoff besteht.

## Revendications

1. Procédé de production d'un barreau monocristallin de silicium présentant une teneur ajustée en une impureté souhaitée répartie de façon pratiquement uniforme dans tout ledit barreau cristallin de silicium, ledit procédé comprenant les étapes suivantes: diffusion d'un élément gazeux polyatomique en tant qu'impureté souhaitée dans la masse d'un barreau polycristallin de silicium, et transformation dudit barreau polycrystallin de silicium où s'est produite la diffusion en un barreau monocristallin de silicium par un procédé de zone flottante.

2. Procédé conforme à la revendication 1, caractérisé en ce que l'étape de diffusion comprend les étapes suivantes: dopage du barreau polycristallin de silicium avec l'impureté souhaitée par diffusion des atomes de l'élément polyatomique gazeux le long des joints de grains des petits cristallites, de façon non-uniforme dans l'espace, à l'intérieur du barreau polycristallin de silicium; et ajustement de la concentration de l'impureté dopante désirée dans le barreau polycristallin de silicium par réalisation de la diffusion de l'élément gazeux pendant un temps donné et à une température donnée.

3. Procédé conforme à la revendication 1 ou 2, dans lequel l'étape de diffusion comprend les étapes suivantes: introduction du barreau polycristallin de silicium dans un four de diffusion réglé à une température donnée; et ensuite, établissement d'un flux contrôlé de l'élément polyatomique gazeux à travers le barreau polycristallin de silicium pendant un temps donné.

4. Procédé conforme à la revendication 1, 2 ou 3, caractérisé en ce que l'étape de transformation est réalisée dans une atmosphère constituée essentiellement de gaz inertes.

5. Procédé conforme à la revendication 1, 2 ou 3, caractérisé en ce que l'étape de transformation est réalisée dans une atmosphère constituée essentiellement de vide.

6. Procédé conforme à la revendication 1, 2 ou 3, caractérisé en ce que l'on réalise la diffusion à l'intérieur du barreau polycristallin de silicium dans une atmosphère constituée essentiellement d'oxygène humide.

7. Procédé conforme à la revendication 1, 2 ou 3, caractérisé en ce que l'on réalise la diffusion à l'intérieur du barreau polycristallin de silicium dans une atmosphère constitué essentiellement d'oxygène sec.

8. Procédé conforme à la revendication 1, 2 ou 3, caractérisé en ce que l'on réalise la diffusion à l'intérieur du barreau polycristallin de silicium dans une atmosphère constituée essentiellement d'azote.

0 114 736

FIG. 1

FIG. 2

FIG. 3

OXYGEN CONCENTRATION (ppma)

$[0]_i \sim 32$ ppma

$[0]_i \sim 18$ ppma

$[0]_i \sim 5$ ppma

SEED

NORMALIZED CRYSTAL
LENGTH

TANG

FIG. 6

O₂ DIFFUSION

FIG. 4

SEED

FIG. 5